# EUROPEAN PATENT APPLICATION

(11) **EP 3 581 951 A1**
(43) Date of publication of application: **18.12.2019**
(21) Application number: 18177381.3
(22) Date of filing: 12.06.2018
(51) Int. Cl.: G01R 33/00

(54) **SENSOR SATURATION FAULT DETECTION**

(71) Applicant: Melexis Bulgaria Ltd., 1138 Sofia (BG)
(72) Inventor: PEEV, Rumen Marinov, 1000 Sofia (BG); GAYDOV, Stoyan Georgiev, 1138 Gorublyane (BG)
(74) Representative: DenK iP

(57) **Abstract**

The present invention relates to a device comprising one or more input devices such as sensors or field sensors, a signal amplifier, and a control circuit. The control circuit controls the input devices at first and second different times to measure and record corresponding input signals S1, S2 and amplified input signals A1, A2. The control circuit determines if the amplified input signal A1 is less than a signal comparator threshold value T and the amplified input signal A2 is greater than or equal to P and less than a signal comparator threshold value T, or determines if A1 is greater than a signal comparator threshold value T and A2 is less than or equal to N and greater than a signal comparator threshold value T, or both. If either is true, then a diagnostic fail signal is provided. If both are false, a sensor measurement signal is provided. Another embodiment employs hysteresis.

## Description

### Field of the invention

The present invention is generally related to the field of integrated sensor diagnostic structures, circuits and methods.

### Background of the invention

Sensors are widely used in electronic devices to measure attributes of the environment and report a measured sensor value. In particular, magnetic sensors are used to measure magnetic fields, for example in transportation systems such as automobiles. Magnetic sensors can incorporate Hall-effect sensors that generate an output voltage proportional to an applied magnetic field or magneto-resistive materials whose electrical resistance changes in response to an external magnetic field.

In many applications it is desirable that sensors are small and are integrated with electronic processing circuitry so as to reduce the overall sensor size and provide improved measurements and integration into external electronic systems. For example, application US2016/299200 describes a Hall-effect magnetic sensor for measuring magnetic fields incorporating an integrated circuit formed in a semiconductor material on a substrate, together with insulation and adhesive layers.

Measurements from sensors can drift over time, providing varying measurements even when exposed to the same field. For example, the field measurements can be offset from a desired nominal value, the sensitivity can vary so that measurements are a multiple (either greater or less than one) of the desired value, or both. Such variation can be the result of changes in environmental conditions, for example temperature or humidity or operational factors, such as vibration or aging. Moreover, devices can fail over time for similar reasons. Furthermore, the materials from which sensors are made can have defects that affect the accuracy, offset bias or symmetry of the magnetic sensor's response.

It is important, therefore, to include diagnostic capabilities to detect faults or failures in complex, safety-critical systems, such as automotive systems, so that repairs can be performed or replacements can be provided for any faulty or failed devices. For example, US 5,553,489 describes a diagnostic system for measuring behaviour of signals provided by a plurality of sensors that includes a plurality of input filters for receiving signals from each of the plurality of sensors and for providing a plurality of filtered sensor signals each derived from the received signals. A signal bandwidth of each of the plurality of filtered sensor signals is lower than the signal bandwidth of the associated received signal. A selection circuit receives each of the signals from each of the plurality of sensors and, dependent on a selection signal, provides a selected sensor signal derived from one of the received signals, wherein the selected sensor signal has a signal bandwidth greater than one of the filtered sensor signals derived from the one of the received signals.

In another example WO2015/038564 describes a method for verifying measurements from a magnetic Hall-effect sensor in a Hall-effect sensor system. In this approach the Hall-effect sensor is excited with an excitation current having a first value. A first measurement corresponding to a voltage output of the Hall-effect sensor when the Hall-effect sensor is excited with the excitation current having the first value is obtained. Additionally, the Hall-effect sensor is excited with the excitation current having a second value, the second value different than the first value. A second measurement corresponding to a voltage output of the Hall-effect sensor when the Hall-effect sensor is excited with the excitation current having the second value is obtained. Operation of the Hall-effect sensor is then verified based at least on the first measurement and the second measurement.

Another approach to managing diagnostics in a magnetic field sensor is described in US2016/252599A1. This design uses switches associated with a magnetic field sensor that provide error information. In particular, a device is provided that includes a magnetic field sensor, a plurality of switches associated with the magnetic field sensor and a control circuit configured to control the plurality of switches and to provide at least one signal indicative of a fault based on operation of the switches.

Yet another design, described in US 9,910,088, provides a method and apparatus for an integrated circuit having a magnetic sensing element and fault detection module coupled to the sensing element, the fault detection module including circuitry to detect a fault condition and to self-test operation of the circuitry for detecting the fault condition. In illustrative embodiments a fault pin indicates the fault condition. US 7,800,389 describes an integrated circuit having a sensor for providing a sensor output signal and a diagnostic circuit coupled to the sensor for providing a self-diagnostic signal. The self-diagnostic signal comprises the sensor output signal during a first time duration and an inverted sensor output signal during a second different time duration.

US 9,652,905 discloses a sensor integrated circuit comprising a controller and a diagnostic module in communication with the controller. The controller is configured for providing a diagnostic reporting signal being a periodic superposition signal on a sensing output of the sensor integrated circuit and/or on a supply current of the sensor integrated circuit. The periodic superposition signal has periodic pulses with a predetermined fixed pulse duration and a predetermined periodicity. The controller furthermore is configured for altering the predetermined periodicity or predetermined fixed pulse duration of the periodic superposition signal upon a fault detection in the diagnostic module communicated to the controller.

US8447556 teaches a magnetic field sensor includes built in self-test circuits that allow a self-test of most of, or all of, the circuitry of the magnetic field sensor, including self-test of a magnetic field sensing element used within the magnetic field sensor, while the magnetic field sensor is functioning in normal operation.

However, these approaches and others similar to them do not necessarily operate the sensor system under critical conditions and can therefore provide a false positive result under such conditions. Moreover, they are subject to faults or defects in the sensor materials leading to incorrect environmental attribute measurements.

There is a need therefore, for circuits and methods in sensor systems that operate and test the sensor systems to detect or correct faults in the sensor under critical test conditions.

### Summary of the invention

It is an object of embodiments of the present invention to provide for a method and device for use in sensor systems to diagnose errors in the correct operation under critical conditions.

The above objective is accomplished by the solution according to the present invention.

In embodiments of the present invention a diagnostic method is disclosed comprising providing one or more input devices, one or more signal comparator threshold values, a signal amplifier, positive and negative signal amplifier saturation threshold values and a control circuit. The input devices can be sensors such as field sensors (e.g., magnetic field sensors) that measure a physical attribute of the environment (e.g., a magnetic field) and are referred to herein as sensors for clarity, but the invention is not limited to such embodiments.

In one embodiment a first amplified input signal (A1) is provided at a first time by setting it equal to a predetermined value. In another embodiment a first amplified input signal A1 is provided by using one or more of the input devices to measure a first input signal S1 at the first time and amplifying the first input signal with the signal amplifier to form the first amplified input signal A1. The one or more input devices provide a second input signal S2 measurement of the physical environmental attribute at a second time different from the first time, such as a time later than the first time. The signal amplifier amplifies the second input signal S2 to form a second amplified input signal A2. The first input signal S1 can be a first sensor signal S1, the second input signal S2 can be a second sensor signal S2, the first amplified input signal A1 can be a first amplified sensor signal A1, and the second amplified input signal A2 can be a second amplified sensor signal A2.

The control circuit can be used to determine if (i) the first amplified input signal A1 is less than a positive signal amplifier saturation threshold value and the second amplified input signal A2 is greater than or equal to the positive signal amplifier saturation threshold value and less than a signal comparator threshold value. The control circuit can also be used to determine if (ii) the first amplified input signal A1 is greater than a negative signal amplifier saturation threshold value and the second amplified input signal A2 is less than or equal to the negative signal amplifier saturation threshold value and greater than a signal comparator threshold value. The control circuit can also be used to determine both (i) and (ii). The control circuit can determine if either (i) or (ii) are true or false, if both (i) and (ii) are true, or if both (i) and (ii) are false. If either (i) or (ii) is true, the control circuit can provide a diagnostic signal that indicates a fault, such as a device fault or a sensor fault. If both (i) and (ii) are false, the control circuit can store or communicate a device signal such as a sensor measurement signal corresponding to a physical attribute of the environment and responsive to or derived from any combination of the first input signal S1, the second input signal S2, the first amplified input signal A1, or the second amplified input signal A2.

In another embodiment the first amplified input signal A1 is set equal to the second amplified input signal A2, a new second signal S2 measurement is performed and amplified to form a new second amplified signal A2, and the first and second amplified signals A1, A2 are tested using the control circuit as described above. Thus, the method can be iterated over time to provide a real-time measurement and diagnostic process using a device of the present invention.

In other embodiments of the diagnostic method the control circuit controls any one or more of the gain of the signal amplifier to determine a desired gain, the positive signal amplifier saturation threshold value, or the negative signal amplifier saturation threshold value. In some embodiments, the sensor signals S1, S2, A1, or A2 are differential signals and the signal amplifier is a differential signal amplifier. The one or more input devices may be sensors such as a Hall-effect magnetic sensor or a magneto-resistive magnetic sensor that sense magnetic fields, or the one or more input devices are bridge sensors or inductive sensors. The input signals and the amplified input signals can be analog signals or digital signals. The input signals and the amplified input signals can be voltage signals.

In some embodiments of the diagnostic method the signal comparator threshold value comprises a positive signal comparator threshold value and a negative signal comparator threshold value less than the positive signal comparator threshold value, and the amplified input signals A1 and A2 are compared to the positive signal comparator threshold value when the amplified input signals A1 and A2 are expected to cross the positive signal comparator threshold value from a smaller signal value less than the positive signal comparator threshold to a greater signal value greater than the positive signal threshold. In some embodiments the amplified input signals A1 and A2 are compared to the negative signal comparator threshold value when the amplified input signals A1 and A2 are expected to cross the negative signal comparator threshold value from a greater signal value greater than the negative signal threshold to a smaller signal value less than the negative signal threshold.

In some embodiments of the present invention, a device comprises one or more input devices such as sensors responsive to an external physical environmental attribute to provide an input or sensor signal, a signal amplifier responsive to the input or sensor signal that outputs an amplified input or sensor signal, and a control circuit responsive to the input or sensor signal and the amplified input or sensor signal. The control circuit includes circuitry that controls the input device or sensor at a first time (e.g., to measure the physical environmental attribute with the sensor) to produce and record a first amplified input or sensor signal A1 and optionally record a first input or sensor signal S1. The control circuit can control the input device or sensor at a second time different from the first time (e.g., a later time to measure the physical environmental attribute with the sensor) to produce a second input or sensor signal S2 and a second amplified input or sensor signal A2.

The control circuit can include circuitry that determines if (i) the first amplified input signal A1 is less than the positive signal amplifier saturation threshold value and the second amplified input signal A2 is greater than or equal to the positive signal amplifier saturation threshold value and less than a signal comparator threshold value. The control circuit can also include circuitry that determines if (ii) the first amplified input signal A1 is greater than the negative signal amplifier saturation threshold value and the second amplified input signal A2 is less than or equal to the negative signal amplifier saturation threshold value and greater than a signal comparator threshold value. In embodiments the control circuit includes circuitry that determines the truth or falsehood of both (i) and (ii). If either (i) or (ii) is true, the control circuitry can provide a sensor diagnostic signal that indicates a device fault using the control circuit. If both (i) and (ii) are false, the control circuitry can store or communicate a sensor measurement signal corresponding to the physical environmental attribute and responsive to or derived from any combination of the first input or sensor signal S1, the second input or sensor signal S2, first amplified input or sensor signal A1, or second amplified input or sensor signal A2 using the control circuit. The control circuit can also output a measurement signal even if a fault is determined and communicated. A diagnostic fail signal can be a diagnostic signal that indicates an error or failure. In other embodiments, the diagnostic signal can indicate normal operation.

In some configurations the control circuit is connected to and controls the signal amplifier with a control signal to control the gain of the signal amplifier to specify a desired gain, controls the positive signal amplifier saturation threshold value or controls the negative signal amplifier saturation threshold value.

In some configurations the input device is a sensor, the signal are sensor signals, the amplified input or sensor signals are differential signals and the signal amplifier is a differential signal amplifier. The input device may be a Hall-effect sensor or a magneto-resistive sensor that senses a physical attribute of the environment such as a magnetic field. The input device may be a bridge sensor or an inductive sensor. The input or sensor signals and the amplified input or sensor signals may be analog signals or digital signals. The input or sensor signals and the amplified input or sensor signals can be voltage signals. The input device may have more than one operational mode, or any combination of these.

Embodiments of the present invention provide input devices or sensors having improved diagnostic capability using smaller and less expensive circuits and can compensate for faults or fine defects in the device material or operating faults in the device components.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The foregoing and other objects, aspects, features, and advantages of the present disclosure will become more apparent and better understood by referring to the following description taken in conjunction with the accompanying drawings.
Fig.1 is a schematic illustration of a circuit according to an illustrative embodiment of the present invention.
Fig.2A, 2B, 2C and 2D are schematic illustrations of measurements and thresholds according to illustrative embodiments of the present invention.
Fig.3 illustrates a schematic illustration of another circuit according to another illustrative embodiment of the present invention.
Fig.4 illustrates a flow chart of a method according to an illustrative embodiment of the present invention.

### Detailed description of illustrative embodiments

The present invention will be described with respect to particular embodiments and with reference to certain drawings but the invention is not limited thereto but only by the claims. The features and advantages of the present disclosure will become more apparent from the detailed description set forth below when taken in conjunction with the drawings, in which like reference characters identify corresponding elements throughout. In the drawings, like reference numbers generally indicate identical, functionally similar, and/or structurally similar elements. The figures are not drawn to scale since the variation in size of various elements in the Figures is too great to permit depiction to scale.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

Embodiments of the present invention provide devices having improved diagnostic capability using smaller and less expensive circuits that can detect or compensate for faults or fine defects in the sensor material or in other elements of the device, or for improper operation of the device. Such defects can be inherent in the material used to make the device or can be formed over time as a result of use or in response to mechanical or other environmental stresses on the device. Other elements of devices, such as integrated circuit controllers, signal amplifiers or comparators, can also fail or operate improperly outside a defined operating range.

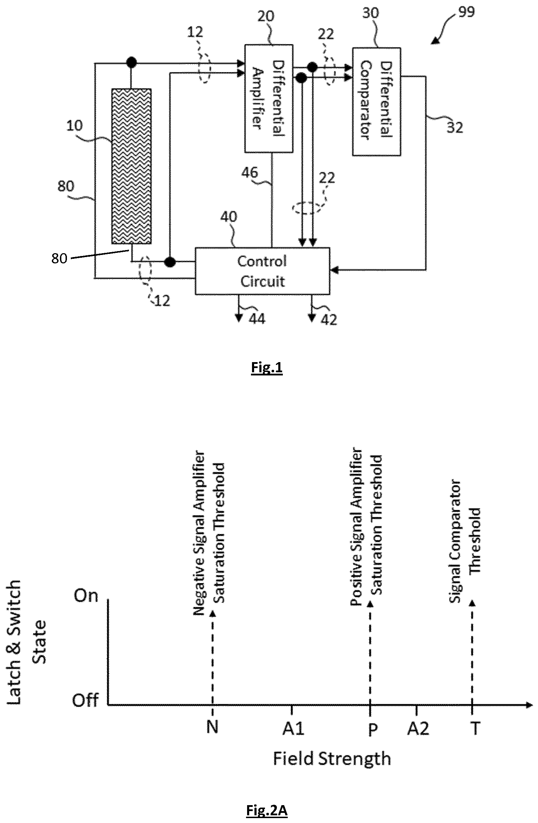

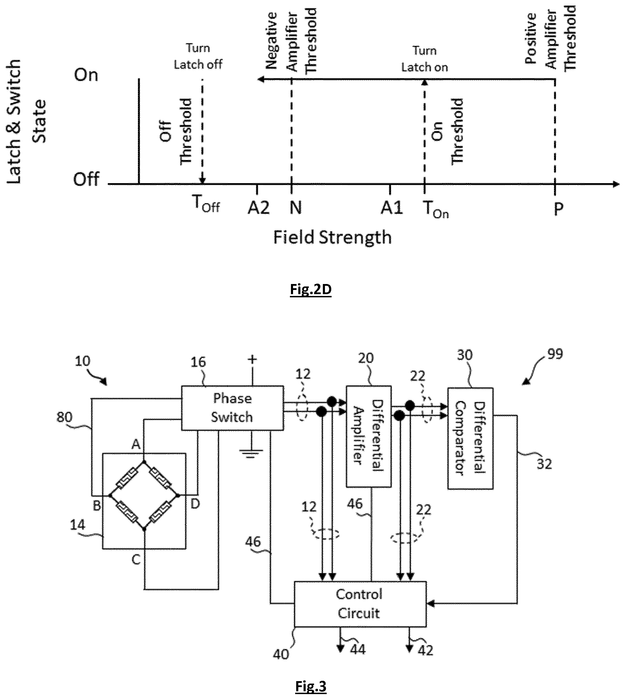

Referring to Figs.1 and 3, a device 99, for example a sensor device 99, comprises one or more input devices 10, for example sensors for sensing a physical attribute of the environment. The input device 10 provides an input signal 12, for example a sensor signal formed in response to a sensed physical environmental attribute, for example a measurement of a physical quantity of the physical environmental attribute. The sensor signal 12 can be a differential signal, for example a signal defined by the difference in voltage between two signal wires 80. Alternatively, the sensor signal 12 can be a voltage on a single wire with reference to a separate bias signal, such as a ground signal.

The device 99 can also comprise a signal amplifier 20 responsive to the input signal 12 that outputs an amplified input signal 22. The signal amplifier 20 can be a differential signal amplifier 20 and the amplified input signal 22 can be a differential signal. The signal amplifier 20 has a predetermined gain value that determines a desired gain or amplification of the input, so that the gain G equals the signal amplifier output divided by the signal amplifier input in a properly functioning system. The gain G can be set by a control signal 46 connected to the signal amplifier 20 from a control circuit 40, for example by a wire 80 and in response to a software or hardware setting in the control circuit 40. The input signal 12 and the amplified input signal 22 can be analog or digital. In a differential signal embodiment a comparator 30 compares the amplified input signals 22 sensed by the input device 10 to produce a comparison signal 32, for example representing a physical quantity of a sensed physical environmental attribute that can be provided to the control circuit 40. In a single ended implementation the amplified input signal sensed by the input device is compared to a reference signal. The input signal 12 and the amplified input signal 22 can be a sensor signal 12 and an amplified sensor signal 22. In various embodiments of the present invention the physical environmental attribute is a magnetic field, an electric field, a pressure field or a gravitational field or a temperature or pressure. The signal amplifier 20 or the comparator 30 can comprise operational amplifiers (opamps), for example connected in amplification or comparator configurations, respectively.

The control circuit 40 includes circuitry, for example analog or digital circuits, including, for example, operational amplifiers or logic circuits. The control circuit 40 can include a memory, for example a digital or an analog memory to store values, such as sensor signals 12 or amplified sensor signals 22. The control circuit 40 can comprise an analog-to-digital convertor to convert analog signals, such as voltages, to corresponding digital signals, amplifiers and comparators.

The control circuit 40 can include a stored program computer or a state machine that provides control to the input device 10 at a first time, for example to measure the physical environmental attribute with a sensor 10 to produce and optionally record a first sensor signal 12 (S1) and produce and optionally record a first amplified sensor signal 22 (A1). The control circuit 40 also provides control to the input device 10 at a second time different from the first time, for example to measure the physical environmental attribute with a sensor 10 at a second time different from the first time (for example a later time) to produce and optionally record a second sensor signal 12 (S2) and produce and optionally record a second amplified sensor signal 22 (A2). The control circuit 40 can also comprise circuitry, including for example arithmetic circuits, either digital or analog, such as adders, multipliers, dividers and comparators.

In embodiments of the present invention the device 99 includes a latch-and-switch circuit that stores values of input sensor signal S1 or S2 if these values, when amplified, reach or exceed a signal comparator threshold value T or that stores amplified input signal A1 or A2 values when the magnitude of the amplified input signal values reaches or exceeds the signal comparator threshold value T. The signal amplifier 20 amplifies both positive and negative signals. The signal amplifier reaches a saturation level at a positive signal amplifier saturation threshold P : input signals S1, S2 cannot be amplified by the signal amplifier 20 to a value greater than P. Similarly, it has a saturation level at a negative signal amplifier saturation threshold N : input signals smaller than N cannot be amplified by the signal amplifier 20 to a value lower than N. The positive and negative signal amplifier saturation threshold values P, N can be set with a margin for error, for example 90% of the physical limitation to avoid overdriving the signal amplifier 20.

In the positive-going transition case, referring to Fig.2A, the control circuit 40 circuitry determines if (test i) the first amplified input or sensor signal A1 is less than the positive signal amplifier saturation threshold value P and the second amplified input signal A2 is greater than or equal to the positive signal amplifier saturation threshold value P and less than the signal comparator threshold value T. In this situation the second amplified signal A2 can never exceed the signal comparator threshold value T since the signal amplifier 20 is in saturation and therefore the signal can never be stored in the latch-and-switch circuit. Thus, the device 99 fails. In a further embodiment of the present invention, if A1 is less than A2, a positive-going transition can be inferred and this test i can be used to detect a fault.

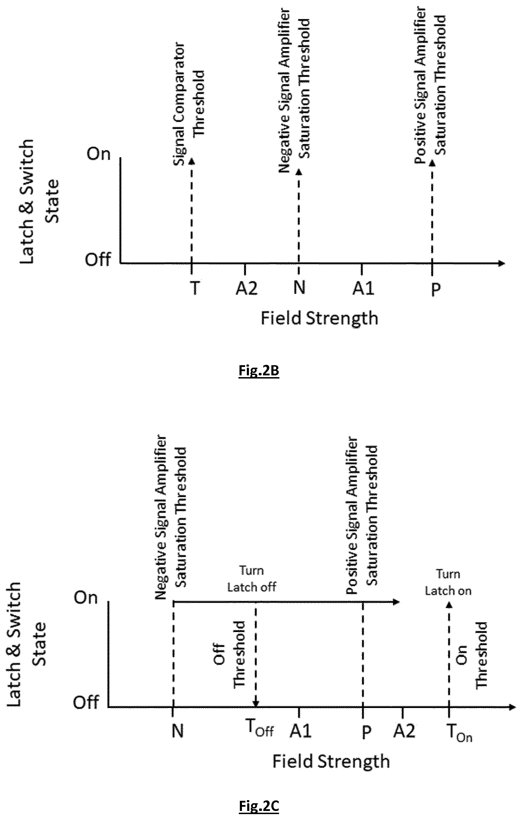

Referring to the negative-going transition case illustrated in Fig.2B, the control circuit can also determine if (test ii) the first amplified signal A1 is greater than the negative signal amplifier saturation threshold value N and the second amplified input or sensor signal A2 is less than or equal to the negative signal amplifier saturation threshold value N and greater than a signal comparator threshold value T. In this situation the second amplified signal A2 can never decrease below the signal comparator threshold value T since the signal amplifier 20 is in saturation and therefore the signal can never be stored in the latch-and-switch circuit. Thus, the device 99 fails. In Fig.2A the second amplified input signal A2 is shown as greater than the positive signal amplifier saturation threshold value P for clarity. In an embodiment the second amplified input signal A2 does not exceed the positive signal amplifier saturation threshold value P since the signal amplifier 20 is in saturation beyond the positive signal amplifier saturation threshold value P. A same remark can be made with respect to Fig.2B. In a further embodiment of the present invention, if A2 is less than A1, a negative-going transition can be inferred and the second test (test ii) can be used to detect a fault.

In the first situation (test i) the amplified input signals A1 or A2 (or both) are expected, in the absence of a fault, to cross the signal comparator threshold value T from a smaller signal value less than the signal comparator threshold T to a greater signal value larger than the signal comparator threshold value T. This behaviour can be assumed at device 99 startup and the input signals are generally expected to increase. This situation can also be assumed if the amplified input signal A2 is, or has recently been, less than the signal comparator threshold value T or latched in a negative or off state.

In the second situation (test ii) the amplified input signals A1 or A2 (or both) are expected to cross the signal comparator threshold value T from a greater signal value larger than the signal threshold T to a smaller signal value less than the signal threshold T. This situation can be assumed if the amplified input signal A2 is, or has recently been, greater than the signal threshold T or latched in a positive or on state.

In embodiments of the present invention the control circuit can maintain a state variable indicating if the input signals are expected to increase or decrease. At start-up the state variable is set to a value indicating an expectation of increasing. Once an amplified signal exceeds the signal comparator threshold value T and is latched (e.g., in an on state), the state variable is set to a value indicating a decrease is expected. Once an amplified signal is less than the signal comparator threshold value T and is latched (e.g., in an off state), the state variable is set to a value indicating an increase in signal amplitude is expected.

Thus, in an embodiment the control circuit 40 determines both (i) if the first amplified input or sensor signal A1 is less than the positive signal amplifier saturation threshold value P and the second amplified input or sensor signal A2 is greater than or equal to the positive signal amplifier saturation threshold value P and less than a signal comparator threshold value T (see test i) and (ii) if the first amplified input or sensor signal A1 is greater than the negative signal amplifier saturation threshold value N and the second amplified input or sensor signal A2 is less than or equal to the negative signal amplifier saturation threshold value N and greater than a signal comparator threshold value T (see test ii). If either (i) or (ii) is true, the control circuit 40 circuitry provides a diagnostic signal 42 indicating a failure, for example an error signal. If both (i) and (ii) are false, the control circuit 40 can store or communicate a measurement signal 44, for example corresponding to a physical attribute of the environment and responsive to or derived from any combination of the first input or sensor signal S1, the second input or sensor signal S2, the first amplified input or sensor signal A1 or the second amplified input or sensor signal A2. Even if a fault is discovered, the control circuit 40 can also output a measurement signal.

Fig.2A illustrates the various signals for a sensor 10 on a graph corresponding to situation (i). The x-axis corresponds to the physical environmental attribute strength (magnitude) and the first and second amplified input signals A1 and A2 are shown both less than the signal comparator threshold value T. The predetermined signal comparator threshold value T is indicated with A1 < T and A2 < T. The y-axis corresponds to a state in which a storage circuit (latch) stores any combination of the first input signal S1, the second input signal S2, the first amplified input signal A1 or the second amplified input signal A2.

If A2 is also in saturation (A2 ≥ P), as shown in Fig.2A, the second amplified input signal A2 can never reach the signal threshold T and latch the amplified input signal A2, for example in a positive direction; thus, the device 99 is in failure mode and a diagnostic signal 42 indicates an error or failure, since the sensed physical environmental attribute signal will never be stored or communicated (latched). In contrast to the illustrated failure mode of the device 99, if the signal amplifier 20 is not in saturation (the signal amplifier 20 is operating within its normal operating range), the second amplified sensor signal A2 is less than positive signal amplifier saturation threshold value P and the signal amplifier 20 has enough range to enable the sensor signal 12 to reach the switching signal comparator threshold value T (T < P, not shown). In this case the device 99 is operating without fault and a measurement signal 44 can be output or stored (latched). If a diagnostic signal 42 is provided, the signal can indicate a normal operating state rather than an error or failure state.

Fig.2A illustrates the case in which the amplified input signals are increasing in a positive direction (becoming larger) but fail to reach the signal threshold T and latch the sensor signal, e.g., amplified input signal A2 does not reach the signal threshold T, because the signal amplifier 20 is in saturation. In another embodiment, referring to Fig.2B, the latch is turning off or latching in a negative direction. In this case the amplified input signals A1 and A2 values are both greater than the signal comparator threshold value T and, as the amplified input signal A2 value decreases, it is desired that the latch turn off in preparation for storing a new amplified input signal A2. In this case, if the amplified input signal A2 is less than or equal to the negative signal amplifier saturation threshold N of the signal amplifier 20, as shown, amplified input signal A2 cannot decrease (e.g., a negative value cannot become more negative) beyond the signal comparator threshold value T and the device 99 is in failure mode and a diagnostic signal 42 indicates an error or failure. If the signal amplifier 20 is not in saturation (i.e. the signal amplifier 20 is operating within its normal operating range), the second amplified sensor signal A2 is greater than the negative signal amplifier saturation threshold value N and the signal amplifier 20 has enough range to enable the sensor signal to decrease below the switching signal comparator threshold value T. In this case the device 99 is operating without fault and a measurement signal 44 can be output or stored. If a diagnostic signal 42 is provided, the signal can indicate a normal operating state rather than an error or failure state. In Fig.2B the second amplified input signal A2 is shown as less than the negative signal amplifier saturation threshold value N for clarity. In an embodiment the second amplified input signal A2 is not less than the negative signal amplifier saturation threshold value N, since the signal amplifier 20 is in saturation at values less than the positive signal amplifier saturation threshold value N. The signal amplifier 20 serves to amplify positive signals to become more positive, for example increasing a 1-volt signal to a 10-volt signal, and also amplify a negative signal to become more negative, for example "increasing" a -1-volt signal to a -10-volt signal. In embodiments of the present invention the negative signals do not have a negative voltage, but are smaller than the corresponding positive signals. As used herein, a positive transition is one that changes from a smaller value to a larger value and a negative transition is one that changes from a larger value to a smaller value, even if the values do not have a negative voltage.

In some embodiments of the present invention the device 99 incorporates hysteresis for the signal threshold T. Referring to Fig.2C, when the amplified input signals A1 and A2 are increasing A1 and A2 are compared to the positive-going signal threshold Tₒₙ,. Note that increasing in this context means that the magnetic field is intended to increase in order to cross the magnetic threshold, but it is clear to the skilled person that the magnetic field, although overall increasing, can have fluctuations or local changes in any direction. Whether the amplified input signals A1 and A2 are less than or greater than the negative-going signal threshold T_{off} is immaterial. As shown in Fig.2C, the device 99 will fail because the amplified input signal A2 is in saturation, at a value less than Tₒₙ, and cannot reach Tₒₙ, latch the device 99 and provide a measurement signal output. Referring to Fig.2D, when the amplified input signals A1 and A2 are decreasing (becoming more negative), A1 and A2 are compared to the negative-going signal threshold T_{off}. Whether the amplified input signals A1 and A2 are less than or greater than the positive-going signal threshold Tₒₙ is irrelevant. As shown in Fig.2D, the device 99 will fail because the amplified input signal A2 is in saturation, greater than T_{off}, and cannot reach T_{off}, latch the device 99, and provide a measurement signal output.

In an embodiment the sensor(s) is/are inductive sensors. In another embodiment the input device or sensor 10 can be a Hall-effect sensor or a magneto-resistive sensor and can be a bridge sensor 14 incorporating multiple input devices or sensors 10 having four circuit connections, A, B, C, D (Fig.3). In one phase two opposing circuit connections are each connected to a voltage bias signal, for example power and ground, and the other two are selected by the phase switch. In another phase the connections are reversed. For example, in the first phase the circuit connections A and C can be electrically connected to first and second voltage bias signals, for example power and ground, respectively, and the circuit connections B and D are selected by the phase switch 16 to provide the differential input or sensor signals 12. In the second phase the circuit connections B and D can be electrically connected to the first and second voltage bias signals, respectively, and the circuit connections A and C are selected by the phase switch 16 to provide the differential input or sensor signals 12. The phase switch 16 can include electronic switches, relays, mechanical switches or any suitable switching mechanism responsive to a control signal 46 from the control circuit 40 for electrically connecting the first and second voltage bias signals and selecting the sensor signals 12. In a further embodiment of the present invention the device 99 has more than two operational phases and can include multiple input devices or sensors 10.

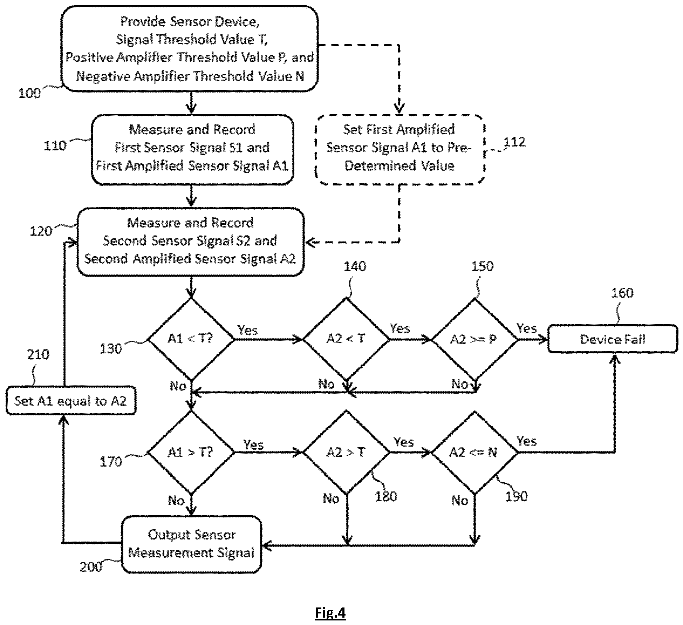

The device 99 can be operated in various methods of the present invention, for example for both positive and negative-going threshold transitions. In some diagnostic methods, referring to Fig.4, a device 99 is provided in step 100, together with the signal comparator threshold value(s) T and the positive and negative signal amplifier saturation threshold values P and N. The provided device 99 can comprise one or more input devices 10, for example sensors 10 responsive to an external physical environmental attribute to produce sensor signals 12 (which can be input signals 12). At a first time in step 110, a first sensor signal 12 and first signal amplified sensor signal 22 responsive to the sensor signal 12 are measured and recorded by the control circuit 40 as the first sensor signal S1 and the first amplified sensor signal A1. Alternatively and as shown in alternative step 112, the first amplified sensor signal A1 can be set equal to a predetermined value as a step in an initialization process when the device is first put into operation. In step 120 the control circuit 40 controls the input device 10 to second measure at a second time different from the first time, for example the sensor 10 measures the physical environmental attribute with the sensor 10 operating to produce a second sensor signal 12 and a second amplified sensor signal 22 that are recorded by the control circuit 40 as the second sensor signal S2 and the second amplified sensor signal A2. In an embodiment only the amplified sensor signals A1, A2 are recorded.

Once the measurement and operating values S1, S2, A1, A2 are taken and recorded, in step 130 the control circuit 40 is used to compare A1 and P. If A1 is less than P, then A2 is compared to T in step 140. In the case incorporating hysteresis, A2 is compared to Tₒₙ. If A2 is less than T, then A2 is compared to the positive signal amplifier saturation threshold value P in step 150. If A2 is greater than or equal to P, a device failure signal is provided in step 160 that indicates a diagnostic fault or error and the diagnostic process completes. If any of steps 130, 140 and 150 are not true, A1 is compared to N in step 170 to determine if A1 is greater than N. If it is, then A2 is compared to T in step 180 to determine if A2 is greater than T. In the case incorporating hysteresis, A2 is compared to T_{off}. If it is, A2 is compared to the negative signal amplifier saturation threshold value N in step 190, and if A2 is less than or equal to N, a device failure signal is provided in step 160 that indicates a diagnostic fault or error and the diagnostic process completes. If any of steps 170, 180 and 190 are not true, the device 99 is operating as desired and an output measurement can be provided (step 200) and, optionally, a diagnostic signal indicating desired operation. After the output signals are provided, the process can begin again by setting signal A1 equal to A2 and then measuring a new signal value S2 and amplified signal value A2. Thus, the method can be iterated over time to provide a real-time measurement and diagnostic process with devices of the present invention.

As will be appreciated by those knowledgeable in the art, some of the steps illustrated in Fig.4 can be performed in a different order. For example, the comparison of A1 with P (step 130) can be done before the second amplified input signal A2 is measured (step 120). The comparisons with amplified input signal A2 (steps 140, 180) can be done before the comparisons with amplified input signal A1 (steps 130, 170). All of steps 170-190 can be done before, rather than after, all of steps 130-150 or some of the steps can be interspersed, so long as the logical result is the same, and steps done in such different orders are included in the present invention.

When the diagnostic process completes with no diagnostic fault (step 200), any combination of the sensor signals 12 or amplified sensor signals 22 can effectively represent a physical quantity of the measured physical attribute of the environment and the comparator 30 provides a valid comparison signal 32 to the control circuit 40. From one or more of the comparison signals 32, for example taken at particular times and combined, the control circuit 40 can produce a measurement signal 44 representing the sensed physical attribute of the environment. In one embodiment the amplified sensor signals A1 and A2 from the first and second time measurements are combined to provide an averaged measurement signal 44. The combined measurements can be a more accurate representation of the physical environmental attribute than any single physical environmental attribute measurement alone.

The input device 10 or sensor 10 can be any of various sensors such as Hall-effect sensors or magneto-resistive sensors and can be provided, for example, in an integrated circuit, discrete elements or as separate integrated circuit components (such as bare die) mounted on a sensor device substrate, such as a glass, ceramic, polymer or semiconductor substrate. One or more of the integrated circuit components or elements of the device 99 such as the signal amplifier, comparator, or control circuit 20, 30, 40, can be disposed on the sensor substrate as bare die deposited by micro-transfer printing or, in the case of a semiconductor substrate, partially or entirely formed in or on the semiconductor substrate and electrically connected using wires 80 formed using photolithographic materials and methods. The input device or sensor 10, the signal amplifier 20, the control circuit 40 or the differential comparator 30 can include electronic circuits, digital logic circuits, analog circuits or mixed-signal circuits, or a combination of circuit types and electronic devices. Portions or all of the input device or sensor 10, the signal amplifier 20, the control circuit 40 or the differential comparator 30 can be provided in one or more common circuits or packages.

The control circuit 40 can include digital logic circuits, analog circuits or mixed-signal circuits, or a combination of circuit types and electronic devices. In some embodiments the control circuit 40 includes a state machine or a central processing unit (e.g., a stored program machine with a program stored in a memory). The control circuit 40 can include a memory, drivers, digital logic circuits and analog circuits. In some embodiments the control circuit 40 includes environmental sensors and the control circuit 40 provides measurement signals 44 in response to the sensed environment, for example the ambient temperature, humidity, vibration, or other physical environmental attributes. Moreover, in some embodiments the control circuit 40 can adapt the measurement signal 44 or the diagnostic signal 42 in response to the environmental conditions using a predetermined calibration of the input device or sensor 10 under those environmental conditions. In other embodiments the control circuit 40 can store a history of use and conditions for the device 99 and adapt the measurement or diagnostic signals 44, 42 in response to the history of use and conditions. For example, components can degrade predictably over time under known environmental conditions or a known pattern of use and the measurement signal 44 or the diagnostic signal 42 adjusted in response to the use or environmental condition history.

In embodiments of the present invention the amount of circuitry required to provide both diagnostic and sensing is reduced by largely using the same circuits for both functions.

The various components of the device 99 can be, for example, provided in electronic circuits, integrated circuits or discrete electronic devices that are electrically connected with wires 80. Any one or all of the various components can be disposed on a printed circuit board or on a semiconductor substrate, or any one or all of the various components can be integrated as a circuit in or on the semiconductor substrate, or some combination of integrated circuits provided on the semiconductor substrate and circuits formed in or the semiconductor substrate. Any one or all of the various components can be provided in packaged integrated circuits or in bare die that are micro-transfer printed onto the semiconductor substrate or other substrate. Wires 80 can be provided using photolithographic methods and materials to connect the various components, integrated circuit dies or circuits integrated on the semiconductor substrate.

Embodiments of the present invention can be constructed by providing a substrate and mounting the input device or sensor 10 on the substrate. In some embodiments the input device or sensor 10, the signal amplifier 20, the comparator 30 and the control circuit 40 are provided in one or more integrated circuits, either packaged or as bare die, and disposed on the substrate surface, for example by micro-transfer printing them from corresponding source wafers onto the substrate surface. Alternatively, the substrate surface can be or include a semiconductor layer and one or more, all of, or any portion of each of the input device or sensor 10, the signal amplifier 20, the comparator 30 and the control circuit 40 are formed in the semiconductor layer and electrically connected with any integrated circuit disposed on the substrate surface using wires 80 on the substrate surface, for example using photolithographic or printed circuit board methods and materials.

The substrate can be one of many substrates with a surface capable of supporting or receiving the input device or sensor 10 and integrated circuits, for example a glass, plastic, ceramic, or semiconductor substrate with two opposing relatively planar and parallel sides. The substrate can have a variety of thicknesses, for example from 10 microns to several millimeters. The substrate can be a portion or surface of another device and can include electronic circuitry. The input device or sensor 10 can be provided in a packaged or unpackaged integrated circuit or in a circuit formed or disposed on, in or in direct contact with the substrate, a surface of the substrate or a layer on the substrate.

If the input device or sensor 10 or one or more or any portion of each of the input devices or sensors 10, the signal amplifier 20, the comparator 30 and the control circuit 40 are micro-transfer printed to the substrate or layers on the substrate (e.g., dielectric layers) they can be electrically connected to each other with wires 80 as desired through vias in any intervening layers (such as the dielectric layer) as is commonly done in the integrated circuit and printed circuit board arts. Alternatively, the input device or sensor 10 or any integrated circuits are surface mount devices and disposed using surface mount techniques. Micro-transfer printed devices can have broken or separated tethers as a consequence of micro-transfer printing from a source wafer to a destination substrate.

Embodiments of the device 99 of the present invention can be operated by providing electrical power to the input device or sensor 10, the signal amplifier 20, the comparator 30 and the control circuit 40. Responsive to the electrical power, the control circuit 40 operates the other elements of the device 99 as described above.

Therefore, as described above, embodiments of the present invention include a diagnostic method, comprising:
i) providing one or more signal comparator threshold values T, a positive signal amplifier saturation threshold value P, a negative signal amplifier saturation threshold value N less than the positive signal amplifier saturation threshold value P, one or more input devices, a signal amplifier and a control circuit;
ii) providing a first amplified input signal A1 at a first time;
iii) providing a second input signal at a second time after the first time using one or more of the input devices and amplifying the second input signal S2 with the signal amplifier to form a second amplified input signal A2;
iv) using the control circuit, determining if (a) the first amplified input signal A1 is less than a signal comparator threshold value T and the second amplified input signal A2 is greater than or equal to the positive signal amplifier saturation threshold value P and less than a signal comparator threshold value T, or determining if (b) the first amplified input signal A1 is greater than a signal comparator threshold value T and the second amplified input signal A2 is less than or equal to the negative signal amplifier saturation threshold value N and greater than the signal comparator threshold value T, or determining both (a) and (b), and if either (a) or (b) is true, providing a diagnostic signal that indicates a fault.

In some embodiments of the present invention the control circuit comprises one or more signal comparators, the control circuit comprises one or more signal amplifier saturation comparators, or the control circuit comprises one or more signal comparators and one or more signal amplifier saturation comparators.

In some embodiments of the present invention, determining if (a) the first amplified input signal A1 is less than a signal comparator saturation threshold value T comprises determining if (a) the first amplified input signal A1 is less than the positive signal amplifier saturation threshold value P, or determining if (b) the first amplified input signal A1 is greater than a signal comparator saturation threshold value T comprises determining if (b) the first amplified input signal A1 is greater than the negative signal amplifier saturation threshold value N, or both.

In some embodiments of the present invention the diagnostic method is done in two or more phases resulting in a single output signal. This can for example be achieved by a sensor signal S1 being a combination of two (or more) spinning phases or by having two (or more) sensor signals that each represent a phase. A phase in this context should be construed as a different bias and readout nodes of a bridge sensor. In some embodiments, the diagnostic signal in any of the two or more phases is a signal processing fault indicating a control circuit fault.

In some embodiments of the present invention the one or more signal comparator threshold values T comprise two signal comparator threshold values T to which the first and second amplified signals A1 and A2 are compared to provide hysteresis.

In some embodiments of the present invention the diagnostic method comprises, using the control circuit, determining if A1 < P and A2 > P then providing a diagnostic signal indicating a fault operation, or determining if A1 > N and A2 < N then providing a diagnostic signal indicating a fault operation.

In some embodiments of the present invention the diagnostic method comprises providing the first amplified input signal A1 at the first time by setting it equal to a predetermined value, using the control circuit.

In some embodiments of the present invention, using the control circuit, the diagnostic method comprises providing the first amplified input signal A1 by providing a first input signal S1 at the first time and amplifying the first input signal with the signal amplifier to form the first amplified input signal A1.

In some embodiments of the present invention, using the control circuit, the diagnostic method comprises providing the first amplified input signal A1 by setting it equal to a second amplified input signal A2 and repeating steps iii) and iv).

In some embodiments of the present invention one or more of the input devices is a sensor that senses a physical attribute of the environment. The one or more sensors can be a Hall-effect magnetic sensor that senses a magnetic field, a magneto-resistive magnetic sensor that senses a magnetic field. The one or more sensors is a bridge sensor, or the one or more sensors is an inductive sensor.

In some embodiments of the present invention the control circuit controls the gain of the signal amplifier to determine one or more desired gain values, the positive signal amplifier saturation threshold value P, and the negative signal amplifier saturation threshold value N.

In some embodiments of the present invention any combination of the input signals S2, A1, or A2 are differential signals and/or the control circuit comprises one or more differential amplifiers.

In some embodiments of the present invention the signal comparator threshold value comprises a positive signal comparator threshold value and a negative signal comparator threshold value less than the positive signal comparator threshold value, and, using the control circuit, the amplified input signals A1 and A2 are compared to the positive signal comparator threshold value when the amplified input signals A1 and A2 are expected to cross the positive signal comparator threshold value from a smaller signal value less than the positive signal threshold to a greater signal value greater than the positive signal threshold, or in some embodiments, using the control circuit, the amplified input signals A1 and A2 are compared to the negative signal comparator threshold value when the amplified input signals A1 and A2 are expected to cross the negative signal comparator threshold value from a greater signal value larger than the negative signal threshold to a smaller signal value less than the negative signal threshold. In some embodiments both comparisons are done.

In some embodiments of the present invention any one or more of the input signal, the amplified input signal, the signal comparator threshold values T, the positive signal amplifier saturation threshold value P and the negative signal amplifier saturation threshold value N are analog signals or digital signals and/or are differential signals.

In some embodiments of the present invention, a device comprises:
- one or more input devices that provide an input signal;
- one or more predetermined signal comparator threshold values T, a predetermined positive signal amplifier saturation threshold value P and a predetermined negative signal amplifier saturation threshold value N less than the positive signal amplifier saturation threshold value P;
- a signal amplifier responsive to the input signal that outputs an amplified input signal;
- a control circuit responsive to the amplified input signal, wherein :
   i) the control circuit controls provides a first amplified input signal A1 at a first time;
   ii) the control circuit controls the one or more input devices at a second time after the first time to produce a second input signal S2 and a second amplified input signal A2; and
   iii) the control circuit determines: a) if (I) the first amplified input signal A1 is less than a signal comparator threshold value T and the second amplified input signal A2 is greater than or equal to the positive signal amplifier saturation threshold value P and less than a signal comparator threshold value T, or if (II) the first amplified input signal A1 is greater than a signal comparator threshold value T and the second amplified input signal A2 is less than or equal to the negative signal amplifier saturation threshold value N and greater than a signal comparator threshold value T, or both (I) and (II), and b) if either (I) or (II) is true, providing a diagnostic fail signal.

In some embodiments of the present invention the control circuit comprises one or more signal comparators, the control circuit comprises one or more signal amplifier saturation comparators or the control circuit comprises one or more signal comparators and one or more signal amplifier saturation comparators.

In some embodiments of the present invention the control circuit determines if (a) the first amplified input signal A1 is less than a signal comparator saturation threshold value T comprises the control circuit determining if (a) the first amplified input signal A1 is less than the positive signal amplifier saturation threshold value P, or the control circuit determining if (b) the first amplified input signal A1 is greater than a signal comparator saturation threshold value T comprises the control circuit determining if (b) the first amplified input signal A1 is greater than the negative signal amplifier saturation threshold value N, or both.

In some embodiments of the present invention the control circuit performs the diagnostic method in two or more phases resulting in a single output signal. This can for example be achieved by a sensor signal S1 being a combination of two (or more) spinning phases or by having two (or more) sensor signals that each represent a phase. A phase in this context should be construed as a different bias and readout nodes of a bridge sensor. The diagnostic signal in any of the two or more phases can be a signal processing fault indicating a control circuit fault.

In some embodiments of the present invention the one or more signal comparator threshold values T comprise two signal comparator threshold values T to which the first and second amplified signals A1 and A2 are compared by the control circuit to provide hysteresis.

In some embodiments of the present invention the control circuit determines if A1 < P and A2 > P and, if so, provides a diagnostic signal indicating a fault operation, or determines if A1 > N and A2 < N and, if so, provides a diagnostic signal indicating a fault operation.

In some embodiments of the present invention the control circuit provides the first amplified input signal A1 by setting it equal to a predetermined value.

In some embodiments of the present invention the control circuit provides the first amplified input signal A1 by providing a first input signal S1 at the first time and amplifying the first input signal with the signal amplifier to form the first amplified input signal A1.

In some embodiments of the present invention the control circuit provides the first amplified input signal A1 by setting it equal to a second amplified input signal A2 and repeating steps ii) and iii).

In some embodiments of the present invention one or more of the input devices is a sensor that senses a physical attribute of the environment. One or more of the sensors can be a Hall-effect sensor that senses a magnetic field or a magneto-resistive sensor that senses a magnetic field, one or more of the sensors is a bridge sensor, or the one or more sensors is an inductive sensor.

In some embodiments of the present invention the control circuit is connected to and controls the signal amplifier with a control signal to control the gain of the signal amplifier to determine one or more of the desired gain values, the positive signal amplifier saturation threshold value P, and the negative signal amplifier saturation threshold value N.

In some embodiments of the present invention the input signal S2 and amplified input signals are differential signals and the signal amplifier is a differential amplifier.

In some embodiments of the present invention a signal comparator threshold value T comprises a positive signal comparator threshold value and a negative signal comparator threshold value less than the positive signal comparator threshold value, and the control circuit compares the amplified input signals A1 and A2 to the positive signal comparator threshold value when the amplified input signals A1 and A2 are expected to cross the positive signal comparator threshold value from a smaller signal value less than the positive signal threshold to a greater signal value greater than the positive signal threshold, or the control circuit compares the amplified input signals A1 and A2 to the negative signal comparator threshold value when the amplified input signals A1 and A2 are expected to cross the negative signal comparator threshold value from a greater signal value larger than the negative signal threshold to a smaller signal value less than the negative signal threshold.

In some embodiments of the present invention any one or more of the sensor signal the amplified input signals A1, A2, the signal comparator threshold values T, the positive signal amplifier saturation threshold value P, and the negative signal amplifier saturation threshold value N are analog signals, digital signals, and/or are differential signals and/or the control circuit comprises one or more differential amplifiers.

In some embodiments of the present invention the input device has more than one operational mode or the control circuit performs the diagnostic method in two or more phases resulting in a single output signal.

Methods of forming micro-transfer printable structures are described, for example, in the paper AMOLED Displays using Transfer-Printed Integrated Circuits (Journal of the Society for Information Display, 2011, DOI # 10.1889/JSID19.4.335, 1071-0922/11/1904-0335, pp. 335-341) and US 8,889,485, referenced above. For a discussion of micro-transfer printing techniques see US 8,722,458, US 7,622,367 and US 8,506,867, the relevant contents of each of which is hereby incorporated by reference. Micro-transfer printing using compound micro-assembly structures and methods can also be used with the present invention, for example, as described in US2016/093600, entitled *Compound Micro-Assembly Strategies and Devices,* the relevant portions of which are hereby incorporated by reference in their entirety. In an embodiment, the device 99 is a compound micro-assembled device. Additional details useful in understanding and performing aspects of the present invention are described in US 9,520,537, entitled *Micro Assembled LED Displays and Lighting Elements.*

### Parts list:

- A, B, C,: D circuit connections
- T: signal comparator threshold value
- Tₒₙ: positive signal comparator threshold value
- T_{off}: negative signal comparator threshold value
- P: positive signal amplifier saturation threshold value
- N: negative signal amplifier saturation threshold value
- 10: input device / sensor
- 12: input signal / sensor signal
- 14: bridge sensor
- 16: phase switch
- 20: signal amplifier
- 22: amplified input signal / amplified sensor signal
- 30: comparator
- 32: comparison signal
- 40: control circuit
- 42: diagnostic signal
- 44: measurement signal
- 46: control signal
- 80: wire
- 99: device / sensor device
- 100: provide sensor device and threshold values step
- 110: measure and record first sensor and amplified sensor signal step
- 112: set amplified sensor signal to predetermined value step
- 120: measure and record second sensor and amplified sensor signal step
- 130: compare first sensor signal to signal comparator threshold value step
- 140: compare second sensor signal to signal comparator threshold value step
- 150: compare second amplified signal to positive signal amplifier saturation threshold value step
- 160: diagnostic fail step
- 170: compare first sensor signal to signal comparator threshold value step
- 180: compare second sensor signal to signal comparator threshold value step
- 190: compare second amplified signal to negative signal amplifier saturation threshold value step
- 200: output sensor measurement signal step
- 210: iterate measurement step

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. A diagnostic method, comprising :
i) providing a signal comparator threshold value (T), a positive signal amplifier saturation threshold value (P), a negative signal amplifier saturation threshold value (N) less than said positive signal amplifier saturation threshold value (P),
ii) providing a first amplified input signal (A1) at a first time;
iii) providing a second input signal at a second time later than said first time and amplifying said second input signal (S2) with said signal amplifier to form a second amplified input signal (A2);
iv) determining if (a) said first amplified input signal (A1) is less than said signal comparator threshold value (T) and said second amplified input signal (A2) is greater than or equal to said positive signal amplifier saturation threshold value (P) and less than said signal comparator threshold value (T), or determining if (b) said first amplified input signal (A1) is greater than said signal comparator threshold value (T) and said second amplified input signal (A2) is less than or equal to said negative signal amplifier saturation threshold value (N) and greater than said signal comparator threshold value (T), or determining both (a) and (b), and if either (a) or (b) is true, providing a diagnostic signal that indicates a fault.

2. Diagnostic method as in claim 1, wherein determining if (a) said first amplified input signal (A1) is less than said signal comparator saturation threshold value (T) comprises determining if (a) said first amplified input signal (A1) is less than said positive signal amplifier saturation threshold value (P), or wherein determining if (b) said first amplified input signal (A1) is greater than said signal comparator saturation threshold value (T) comprises determining if (b) said first amplified input signal (A1) is greater than said negative signal amplifier saturation threshold value (N), or both.

3. Diagnostic method as in claim 1 or 2, wherein the diagnostic method is done in two or more phases resulting in a single output signal.

4. Diagnostic method as in any of claims 1 to 3, wherein said first (A1) and second (A2) amplified signals are compared to said signal comparator threshold value and a further signal comparator threshold value to provide hysteresis.

5. Diagnostic method as in any of the previous claims, comprising determining if A1 < P and A2 > P and, if so, then providing a diagnostic signal indicating a fault operation, or determining if A1 > N and A2 < N and, if so, then providing a diagnostic signal indicating a fault operation.

6. Diagnostic method as in any of the previous claims, comprising providing said first amplified input signal (A1) at said first time by setting it equal to a predetermined value.

7. Diagnostic method as in any of the previous claims, comprising providing said first amplified input signal (A1) by setting it equal to a second amplified input signal (A2) and repeating steps iii) and iv).

8. Diagnostic method as in any of the previous claims, wherein said signal comparator threshold value comprises a positive signal comparator threshold value and a negative signal comparator threshold value less than the positive signal comparator threshold value, and wherein said amplified input signals (A1, A2) are compared to said positive signal comparator threshold value when said amplified input signals (A1, A2) are expected to cross said positive signal comparator threshold value from a smaller signal value less than said positive signal threshold to a greater signal value greater than said positive signal threshold, or wherein said amplified input signals A1 and A2 are compared to said negative signal comparator threshold value when said amplified input signals (A1, A2) are expected to cross said negative signal comparator threshold value from a greater signal value larger than said negative signal threshold to a smaller signal value less than said negative signal threshold, or both.

9. A device comprising:
- one or more input devices arranged to provide an input signal;
- a predetermined signal comparator threshold value T, a predetermined positive signal amplifier saturation threshold value P and a predetermined negative signal amplifier saturation threshold value N less than the positive signal amplifier saturation threshold value P;
- a signal amplifier responsive to the input signal arranged to output an amplified input signal;
- a control circuit responsive to said amplified input signal, wherein the control circuit is arranged to
i) provide a first amplified input signal A1 at a first time;
ii) control said one or more input devices at a second time after said first time to produce a second input signal S2 and a second amplified input signal A2; and
iii) determine: a) if (I) said first amplified input signal A1 is less than said signal comparator threshold value T and said second amplified input signal A2 is greater than or equal to said positive signal amplifier saturation threshold value P and less than said signal comparator threshold value T, or if (II) said first amplified input signal A1 is greater than said signal comparator threshold value T and said second amplified input signal A2 is less than or equal to said negative signal amplifier saturation threshold value N and greater than said signal comparator threshold value T, or both (I) and (II), and b) if either (I) or (II) is true, providing a diagnostic fail signal.

10. Device as in claim 9, wherein said control circuit is arranged to determine if (a) said first amplified input signal A1 is less than said signal comparator saturation threshold value T by determining if said first amplified input signal A1 is less than said positive signal amplifier saturation threshold value P, or arranged to determine if (b) said first amplified input signal A1 is greater than said signal comparator saturation threshold value T by determining if (b) said first amplified input signal A1 is greater than said negative signal amplifier saturation threshold value N, or both.

11. Device as in claim 9 or 10, wherein said control circuit is arranged to perform the diagnostic method in two or more phases resulting in a single output signal.

12. Device as in any of claims 9 to 11, wherein said control circuit is arranged to compare said first and second amplified signals A1 and A2 to said signal comparator threshold value T and to a further signal comparator threshold value, to provide hysteresis.

13. Device as in any of claims 9 to 12, wherein said control circuit is arranged to determine if A1 < P and A2 > P and if so, to provide a diagnostic signal indicating faulty operation, or to determine if A1 > N and A2 < N and if so, to provide a diagnostic signal indicating faulty operation.

14. Device as in any of claims 9 to 13, wherein said control circuit is arranged to provide said first amplified input signal A1 by setting it equal to a second amplified input signal A2 and to control said one or more input devices to produce a further second input signal and a further second amplified input signal.

15. Device as in any of claims 9 to 14, wherein said signal comparator threshold value T comprises a positive signal comparator threshold value and a negative signal comparator threshold value less than the positive signal comparator threshold value, and wherein the control circuit is arranged to compare said amplified input signals A1 and A2 to said positive signal comparator threshold value when said amplified input signals A1 and A2 are expected to cross said positive signal comparator threshold value from a smaller signal value less than said positive signal threshold to a greater signal value greater than said positive signal threshold, or said control circuit compares the amplified input signals A1 and A2 to said negative signal comparator threshold value when said amplified input signals A1 and A2 are expected to cross said negative signal comparator threshold value from a greater signal value larger than said negative signal threshold to a smaller signal value less than said negative signal threshold.
